# EUROPEAN PATENT APPLICATION

(11) **EP 3 767 611 A1**
(43) Date of publication of application: **20.01.2021**
(21) Application number: 18909689.4
(22) Date of filing: 29.06.2018
(51) Int. Cl.: G09F 9/30

(54) **BENDING COMPONENT AND FLEXIBLE DISPLAY DEVICE**

(30) Priority: 12.03.2018 WO PCT/CN2018/078691; 12.03.2018 WO PCT/CN2018/078689; 12.03.2018 WO PCT/CN2018/078690
(71) Applicant: Shenzhen Royole Technologies Co., Ltd, Shenzhen, Guangdong 518172 (CN)
(72) Inventor: FAN, Xiaofei, Shenzhen, Guangdong 518172 (CN)
(74) Representative: Mewburn Ellis LLP
(86) International application number: PCT/CN2018/093765
(87) International publication number: WO 2019/174156

(57) **Abstract**

A bendable assembly (10) including a hinge module (12) and a linkage module (14). The hinge module (12) includes a first connecting hinge (122) and a second connecting hinge (124) respectively disposed at two opposite sides of the hinge module (12). The linkage module (14) is connected and arranged between the first connecting hinge (122) and the second connecting hinge (124). When the first connecting hinge (122) rotates, the linkage module (14) transmits a rotation of the first connecting hinge (122) to the second connecting hinge (124) to drive the second connecting hinge (124) to rotate. Operation convenience in state switching of the bendable assembly (10) and a flexible display device (100) can be realized, and user experience is improved.

## Description

### TECHNICAL FIELD

This disclosure relates to the technical field of flexible displays, and particularly to a bendable assembly and a flexible display device.

### BACKGROUND

Flexible display screens are increasingly favored by consumers due to their flexibility. The flexible display screen can be switched between a bent state and an unfolded state. Existing mechanisms can no longer meet requirements for state switch of the flexible display screen, and thus it is necessary to provide a new structural design.

### SUMMARY

According to the present disclosure, a bendable assembly and a flexible display device are provided.

A bendable assembly is provided according to the present disclosure. The bendable assembly includes a hinge module and a linkage module. The hinge module includes a first connecting hinge and a second connecting hinge respectively disposed at two opposite sides of the hinge module. The linkage module is connected and arranged between the first connecting hinge and the second connecting hinge. When the first connecting hinge rotates, the linkage module transmits a rotation of the first connecting hinge to the second connecting hinge to drive the second connecting hinge to rotate.

A flexible display device is provided according to embodiments of the present disclosure. The flexible display device includes the bendable assembly provided above and a flexible display assembly disposed on the bendable assembly.

In the bendable assembly and the flexible display device according to the embodiments of the present disclosure, when switching the hinge module between a bent state and an unfolded state, the linkage module interlocks the first connecting hinge with the second connecting hinge, it is possible to switch the hinge module between the bent state and the unfolded state by operating the first connecting hinge or the second connecting hinge, and thus it is easy to realize state switch of the bendable assembly and the flexible display device, and user experience is accordingly improved.

Additional aspects and advantages of the present disclosure will be partly presented in the following description, partly become apparent in the following description or be appreciated in practicing of the present disclosure.

### BRIEF DESCRIPTION OF THE DRAWINGS

Above and/or additional aspects and advantages of the present disclosure will be apparent and readily appreciated from the following description of embodiments with reference to the accompanying drawings, in which:
FIG. 1 is a schematic view of a bendable assembly in a bent state according to an embodiment of the present disclosure.
FIG. 2 is a schematic view of the bendable assembly in an unfolded state according to an embodiment of the present disclosure.
FIG. 3 is a partially exploded schematic view of the bendable assembly according to an embodiment of the present disclosure.
FIG. 4 is a schematic view of a linkage module according to an embodiment of the present disclosure.
FIG. 5 is a schematic view of a first connecting member according to an embodiment of the present disclosure.
FIG. 6 is a schematic view of a first shaft according to an embodiment of the present disclosure.
FIG. 7 is a schematic view of a second shaft according to an embodiment of the present disclosure.
FIG. 8 is a schematic plan view of a first damping pieces according to an embodiment of the present disclosure.
FIG. 9 is a schematic view of a third connecting member according to an embodiment of the present disclosure.
FIG. 10 is a schematic view of a first connecting hinge according to an embodiment of the present disclosure.
FIG. 11 is a schematic view of a first hinge according to an embodiment of the present disclosure.
FIG. 12 is a schematic view of a second hinge according to an embodiment of the present disclosure.
FIG. 13 is a partially exploded view of the bendable assembly of according to an embodiment of the present disclosure.
FIG. 14 is a schematic plan view of the bendable assembly according to an embodiment of the present disclosure.
FIG. 15 is a schematic view of a first assembling member according to an embodiment of the present disclosure.
FIG. 16 is a schematic view of a second assembly member according to an embodiment of the present disclosure.
FIG. 17 is a schematic view of a third assembly member according to an embodiment of the present disclosure.
FIG. 18 is a front view of a flexible display device according to an embodiment of the present disclosure.
FIG. 19 is a schematic rear view of the flexible display device according to an embodiment of the present disclosure.
FIG. 20 is a schematic view of a first support plate according to an embodiment of the present disclosure.

Reference numbers indicating main members are described as follows:
flexible display device 100, bendable assembly 10, hinge module 12, first connecting hinge 122, first fastening groove 1222, first fastening hole 1224, second connecting hinge 124, second fastening groove 1242, second fastening hole 1244, rotatable hinge 126, first hinge 1262, first connecting portion 126a, second hinge 1264, first accommodation space 126b, third hinge 1266, linkage module 14, first gear set 141, first gear 1412, second gear 1414, third gear 1416, first connecting member 142, first piece 1422, first ring part 1424, second gear set 144, fourth gear 1442, fifth gear 1444, sixth gear 1446, first shaft 145, first rod 1452, first convex portion 1454, second rod 1456, second shaft 146, third rod 1462, second convex portion 1464, first non-cylindrical portion 146a, first cylindrical portion 146b, fourth rod 1466, third gear set 147, seventh gear 1472, eighth gear 1474, ninth gear 1476, third shaft 148, fifth rod 1482, third convex portion 1484, sixth rod 1486, fourth shaft 149, seventh rod 1492, fourth convex portion 1494, eighth rod 1496, first damping module 16, first damping pieces 162, first notch 1622, second damping module 18, second damping pieces 182, second notch 1822, third connecting member 11, first shaft connector 112, first base plate 114, first fastener 116, fourth connecting member 13, second shaft connector 132, second base plate 134, second fastener 136, first plate 15 , second plate 17, first assembling member 10a, second assembling member 10b, third assembling member 10c, flexible display assembly 20, flexible display screen 22, first support plate 24, second support plate 26.

### DETAILED DESCRIPTION OF ILLUSTRATED EMBODIMENTS

Embodiments of the present disclosure will be described in detail as following and examples of the embodiments will be illustrated in the accompanying drawings, where same or similar reference numerals are used to indicate same or similar members or members with same or similar functions. The embodiments described herein with reference to the accompanying drawings are exemplary, and are intended to describe the present disclosure and cannot be construed as a limitation to the present disclosure.

In the description of the present disclosure, it is to be understood that, orientations or position relationships indicated by terms such as "center", "longitudinal", "transverse", "length", "width", "thickness", "upper", "lower", "front", "rear", "left", "right", "vertical", "horizontal", "top", "bottom", "inner", "outer", "clockwise", and "counterclockwise" are orientations or position relationships shown based on the accompanying drawings, and are merely used for describing the present disclosure and simplifying the description, rather than indicating or implying that the apparatus or element should have a particular orientation or be constructed and operated in a particular orientation, and therefore, should not be construed as a limitation to the present disclosure.

In addition, terms "first" and "second" are used only for description purposes, and shall not be understood as indicating or suggesting relative importance or implicitly indicating a quantity of indicated technical features. Therefore, features defined by "first" and "second" may explicitly or implicitly include one or more of the above-mentioned features. In the description of the present disclosure, unless otherwise specifically limited, "multiple", "a plurality of", and "a number of" mean there are at least two elements.

In the embodiments of the present disclosure, it is appreciated that terms "dispose", "interconnect", and "connect" should be understood in a broad sense unless otherwise specified and limited. For example, terms "interconnect" and "connect" may refer to fixedly connect, detachably connect, or integrally connect. The terms "interconnect" and "connect" may also refer to mechanically connect, electrically connect, or communicate with each other. The terms "interconnect" and "connect" may also refer to directly connect, indirectly connect through an intermediate medium, intercommunicate interiors of two elements, or interact between two elements. For those of ordinary skill in the art, the specific meanings of the above terms in the embodiments of the present disclosure can be understood according to specific situations.

In the embodiments of the present disclosure, unless otherwise specified and limited, a first feature being disposed "above" or "below" a second feature may indicate that the first feature and the second feature are directly contacted with each other, or the first feature and the second feature are indirectly contacted via an intermediate medium. Moreover, the first feature being disposed "above" the second feature may indicate that the first feature is directly above or obliquely above the second feature, or merely indicate that the first feature is higher in horizontal height than the second feature. The first feature being disposed "below" the second feature may indicate that the first feature is directly below or obliquely below the second feature, or merely indicate that the first feature is lower in the horizontal height than the second feature.

Various embodiments or examples are provided herein for realizing various structures. To simplify the disclosure of the present disclosure, components and arrangements of specific examples are described below, and of course, are only exemplary and are not intended to limit the present disclosure. In addition, same reference numerals and/or reference letters can be repeated in different embodiments according to the present disclosure, and such repetition is for the purpose of simplification and clarity, without indicating the relationships between various embodiments and/or arrangements in discuss. Moreover, the present disclosure provides examples of various specific processes and materials, but the applicability of other processes and/or disclosure of other materials may be appreciated by those having ordinary skill in the art.

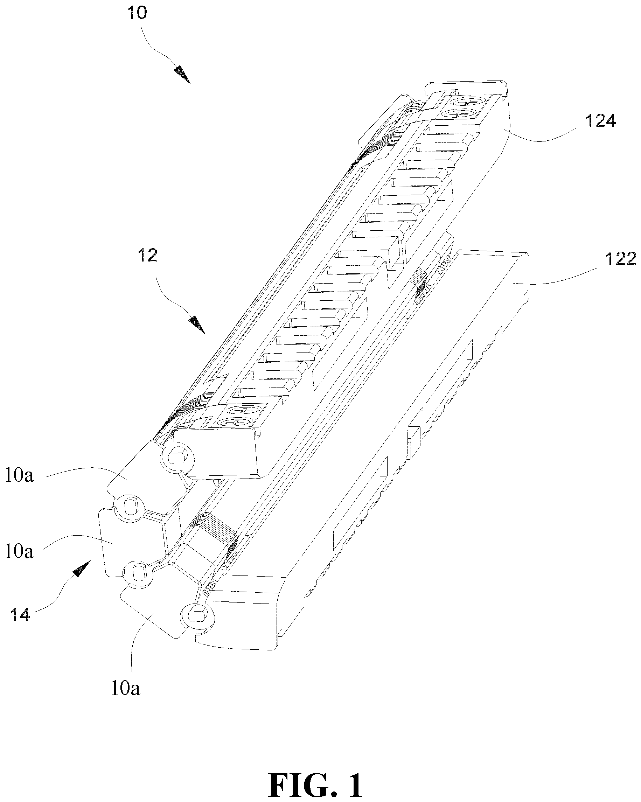

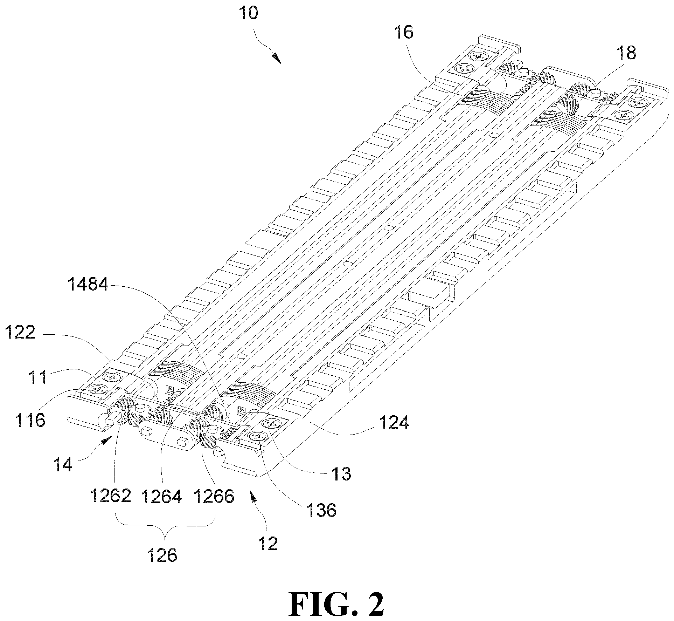

Referring to FIG. 1 and FIG. 2, a bendable assembly 10 is provided according to the embodiments of the present disclosure. The bendable assembly 10 includes a hinge module 12 and a linkage module 14. The hinge module 12 includes a first connecting hinge 122 and a second connecting hinge 124 respectively disposed at two opposite sides of the hinge module 12. The linkage module 14 is connected with and arranged between the first connecting hinge 122 and the second connecting hinge 124. When the first connecting hinge 122 rotates, the linkage module 14 transmits a rotation of the first connecting hinge 122 to the second connecting hinge 124, thus driving the second connecting hinge 124 to rotate.

According to the embodiments of the present disclosure, when switching the hinge module 12 of the bendable assembly 10 between a bent state and an unfolded state, since the linkage module 14 interlocks the first connecting hinge 122 with the second connecting hinge 124, it is possible to switch the hinge module 12 between the bent state and the unfolded state by operating the first connecting hinge 122 or the second connecting hinge 124, and thus it is easy to realize state switch of the bendable assembly 10 and user experience is accordingly improved.

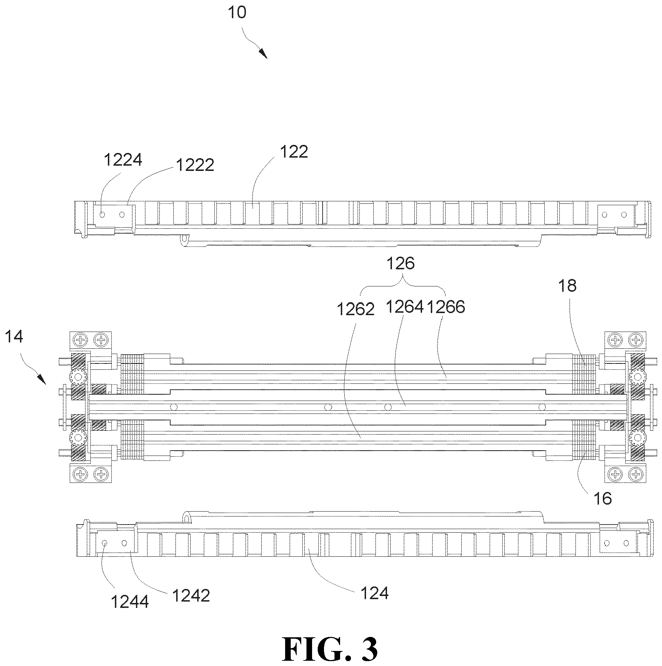

Referring to FIG. 2 and FIG. 3, in some embodiments, the hinge module 12 includes a rotatable hinge 126, and the first connecting hinge 122 and the second connecting hinge 124 are rotatably connected to two opposite sides of the rotatable hinge 126, respectively.

In addition, the first connecting hinge 122 and the second connecting hinge 124 are each in a substantially elongated shape and include hollow portions. A portion of the first connecting hinge 122 is rotatably connected with and fitted with a side portion of the rotatable hinge 126 via shaft elements, and a portion of the second connecting hinge 124 is rotatably connected with and fitted with another side portion of the rotatable hinge 126 via shaft elements, thereby improving space utilization on premise of ensuring stability of rotational connections.

The first connecting hinge 122 defines first fastening grooves 1222 at two opposite ends of the first connecting hinge 122, and the second connecting hinge 124 defines second fastening grooves 1242 at two opposite ends of the second connecting hinge 124. In the first fastening groove 1222, a first fastening hole 1224 is defined. In the second fastening groove 1242, a second fastening hole 1242 is defined. A first fastener 116 passes through the rotatable hinge 126 and is locked with the first fastening hole 124, and a second fastener 136 passes through the rotatable hinge 126 and is locked with the second fastening hole 1244, thus the rotatable hinge 126 connects with the first connecting hinge 122 and the second connecting hinge 124. In an embodiment, the first fastener 116 and the second fastener 136 are screws, and the first fastening hole 1224 and the second fastening hole 1244 are screw holes. Screw engagements between screws and screw holes can provide a relatively good fixed connection, and thus structural stability of the hinge module 12 can be ensured, and high repeatability and easy disassembly can be provided.

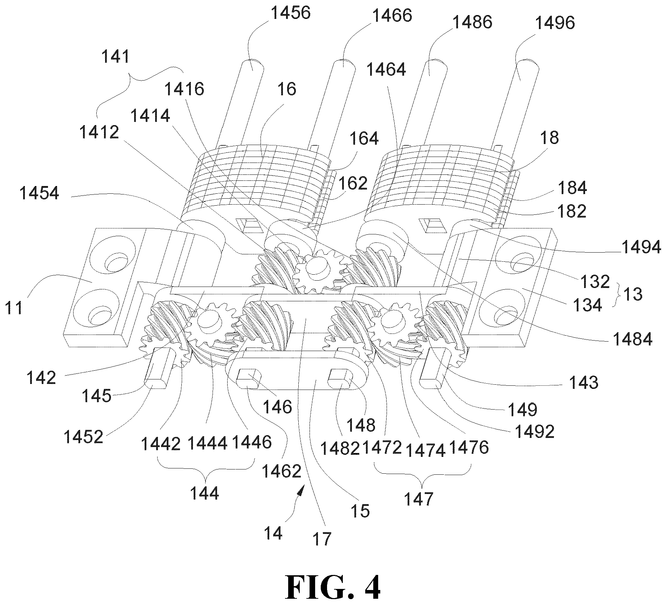

Referring to FIG. 2 and FIG. 4, in some embodiments, the linkage module 14 includes a first gear set 141, a first connecting member 142, and a second connecting member 143. The first connecting member 142 interlocks the first connecting hinge 122 with the first gear set 141. The second connecting member 143 interlocks the second connecting hinge 124 with the first gear set 141. The first connecting hinge 122 can drive the first connecting member 142 to rotate. In an embodiment, the first connecting hinge 122 drives the first connecting member 142 to rotate as follows. The rotation of the first connecting hinge 122 drives the third connecting piece 11 to rotate. Since the third connecting member 11 and a first shaft 145 are fixed together through an engagement between flat surfaces, a rotation of the third connecting member 11 can exert a force against the first shaft 145, and the first shaft 145 subjected to the force can drive the first connecting member 142 to rotate about a second shaft 146. Since the first connecting member 142 and the first gear 1412 are fixed by welding, a rotation of the first connecting member 142 enables the first gear 1412 to rotate about the second shaft 146 with the first connecting member 142. In this way, the rotation of the first connecting hinge 122 about the second rotating shaft 146 is implemented. The first gear set 141 can transmit the rotation of the first connecting member 142 to the second connecting member 143 to rotate the second connecting member 143, and a rotation of the second connecting member 143 can drive the second connecting hinge 124 to rotate.

In this way, through connections and rotation transmissions among the first gear set 141, the first connecting member 142, and the second connecting member 143, a linkage configuration of the linkage module 14 is achieved, thus simplifying position relationship among components of the linkage module 14 and provide a clear structure and easy production and assembly of the linkage module 14.

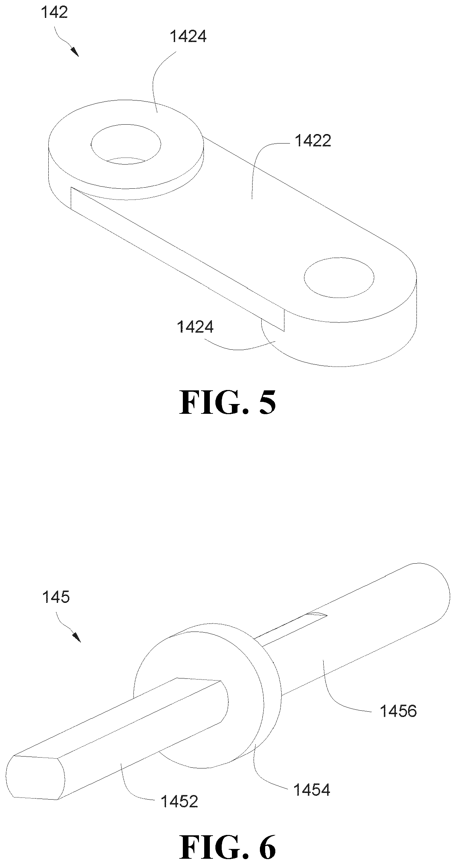

In an embodiment, referring to FIG. 4 and FIG. 5, the first connecting member 142 includes a first piece 1422 and two first ring portions 1424. The two first ring portions 1424 are respectively disposed, facing away from each other, on two opposite ends of the first piece 1422. The second connecting member 143 is the same as the first connecting member 142 in structure. When assembling, the first connecting member 142 and the second connecting member 143 are positioned in opposite directions. In an embodiment, the first ring portions 1424 define through holes through which the first shaft 145 and the second shaft 146 respectively pass, thereby facilitating the assembly of the bendable assembly 10.

Referring to FIG. 4 again, the first gear set 141 includes a first gear 1412, a second gear 1414, and a third gear 1416. The second gear 1414 is rotatably connected with the first gear 1412 and the third gear 1416. The first gear 1412 is fixedly connected with the first connecting member 142. The third gear 1416 is fixedly connected with the second connecting member 143.

Moreover, the first gear 1412 and the third gear 1416 are meshed with the second gear 1414. An axis about which the second gear 1414 rotates is perpendicular to an axis about which the first gear 1412 rotates and an axis about which the third gear 1416 rotates. It can be understood that, the first gear 1412 rotates in a direction opposite to a direction in which the third gear 1416 rotates. When any one of the first gear 1412, the second gear 1414, or the third gear 1416 rotates, the other two can rotate synchronously, such that the linkage configuration of the linkage module 14 can be realized and the bendable assembly 10 can be driven to rotate synchronously. The first gear 1412 can be connected to the first connecting member 142 by welding and the third gear 1416 can be connected to the second connecting member 143 by welding. Welding process is easy to implement and provides a relatively stable fixed connection.

In an embodiment, the first gear 1412 is fixedly connected to one of the two first ring portions 1424 of the first connecting member 142. The first gear 1412 defines a gear through hole that can cooperate with the first ring portion 1424. Moreover, a cross-sectional dimension of the first gear 1412 is equal to or slightly smaller than that of the first ring portion 1424 to ensure that the linkage module 14 has a regular appearance and normal rotation. A connection between the third gear 1416 and the second connecting member 143 is similar to that between the first gear 1412 and the first connecting member 142, and therefore will not be described in detail herein.

Embodiments of the fixed connection between the first gear 1412 and the first connecting member 142 and the fixed connection between the third gear 1416 and the second connecting member 143 can be accomplished by using any suitable process that is not limited to welding, which can be specifically determined based on a specific embodiment. For example, the first gear 1412 and the first connecting member 142 may be integrally formed and the third gear 1416 and the second connecting member 143 may be integrally formed, so as to improve the integrity. In another example, the first gear 1412 and the first connecting member 142 can be fixedly connected by adhesive bonding, and the third gear 1416 and the second connecting member 143 can be fixedly connected by adhesive bonding. In an embodiment, the first gear 1412, the second gear 1414, and the third gear 1416 are helical gears.

Referring to FIG. 4, in some embodiments, the linkage module 14 includes a second gear set 144, a first shaft 145, and a second shaft 146. The first shaft 145 is connected with the second gear set 144, the first connecting member 142, the first connecting hinge 122, and the rotatable hinge 126. The second shaft 146 is connected with the second gear set 144, the first gear set 141, the first connecting member 142, and the rotatable hinge 126.

Moreover, referring to FIGS. 2, 4, and 6, the first shaft 145 includes a first convex portion 1454, a first rod 1452, and a second rod 1456. The first rod 1452 and the second rod 1456 are connected to two opposite sides of the first convex portion 1454, respectively. The first rod 1452 has a cross section in a non-circular shape, such as in a flat ellipse or racetrack shape. The second rod 1456 is in a substantially cylindrical shape. The first rod 1452 is connected with the second gear set 144 and the first connecting member 142, and the second rod 1456 is rotatably connected with the first connecting hinge 122 and the rotatable hinge 126. The first shaft 145 may be an integral structure or a combination of the first rod 1452, the second rod 1456, and the first convex portion 1454.

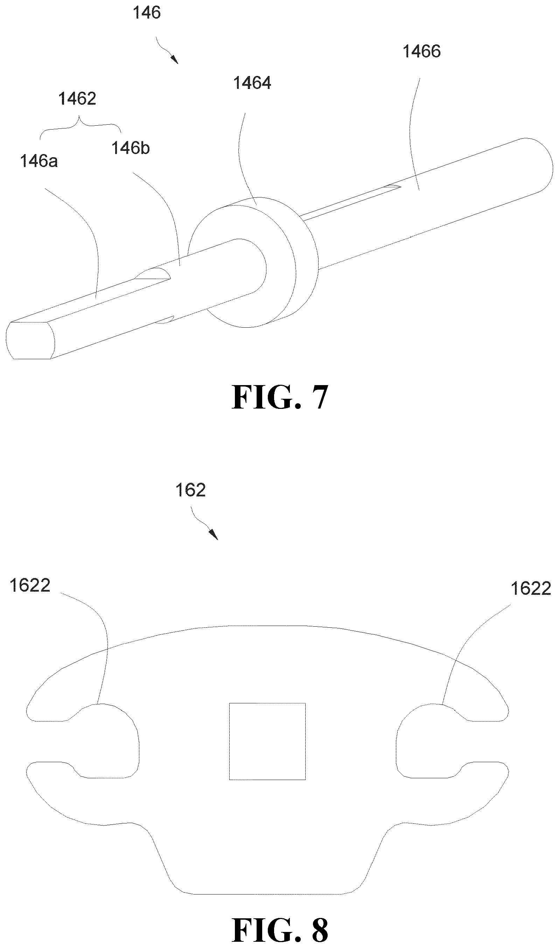

Referring to FIG. 7 together, the second shaft 146 includes a second convex portion 1464, a third rod 1462, and a fourth rod 1466. The third rod 1462 and the fourth rod 1466 are connected to two opposite sides of the second convex portion 1464, respectively. The third rod 1462 includes a first non-cylindrical portion 146a and a first cylindrical portion 146b. The first cylindrical portion 146b is connected with the first non-cylindrical portion 146a and the second convex portion 1464. The fourth rod 1466 is in a substantially cylindrical shape. The first gear 1412 and a corresponding first ring portion 1424 of the first connecting member 142 are rotatably disposed on the first cylindrical portion 146b. The first non-cylindrical portion 146a may have a cross section in a non-circular shape, such as in a flat ellipse shape, racetrack shape, or triangle shape. The second gear set 144 is disposed at the first non-cylindrical portion 146a.

The second rod 1456 and the rotatable hinge 126 are rotatably connected with the first connecting hinge 122, and the fourth rod 1466 is rotatably connected with the rotatable hinge 126.

Referring to FIG. 4, the second gear set 144 includes a fourth gear 1442, a fifth gear 1444, and a sixth gear 1446. The fifth gear 1444 is rotatably connected with the fourth gear 1442 and the sixth gear 1446. The fourth gear 1442 is disposed on the first shaft 145 and non-rotatable with respect to the first shaft 145. The sixth gear 1446 is fixed on the second shaft 146 and non-rotatable relative to the second shaft 146.

Moreover, the fourth gear 1442 and the sixth gear 1446 are meshed with the fifth gear 1444. An axis about which the fifth gear 1444 rotates is perpendicular to an axis about which the fourth gear 1442 rotates and an axis about which the sixth gear 1446 rotates. It can be understood that the fourth gear 1442 rotates in a direction opposite to a direction in which the sixth gear 1446 rotates. When any one of the fourth gear 1442, the fifth gear 1444, or the sixth gear 1446 rotates, the other two can rotate synchronously, such that the linkage configuration of the linkage module 14 can be realized and the bendable assembly 10 can be driven to rotate synchronously.

The fourth gear 1442 is fixedly connected with the other one of the two first ring portions 1424 of the first connecting member 142. The fourth gear 1442 defines a gear through hole, and a cross section of the gear through hole cooperates with a cross section of the first rod 1452 of the first shaft 145. For example, the cross section of the gear through hole in the fourth gear 1442 is in a flat ellipse shape or racetrack shape, such that the first rod 1452 extends through and cooperates with the gear through hole in the fourth gear 1442 to drive the linkage module 14 to rotate. The sixth gear 1446 is similar in structure to the fourth gear 1442, and therefore will not be described in detail. A cross-sectional dimension of the fourth gear 1442 is equal to or slightly smaller than that of the first ring portion 1424 to ensure that the linkage module 14 has a regular appearance and normal rotation.

More specifically, in an embodiment as illustrated in the drawings, the sixth gear 1446 is disposed on the first non-cylindrical portion 146a. The sixth gear 1446 defines a gear through hole, where a cross section of the gear through hole cooperates with the cross section of the first non-cylindrical portion 146a. The first gear 1412 is fixedly connected to the first ring portion 1424. The first gear 1412 and the first ring portion 1424 are disposed on the first cylindrical portion 146b and can rotate relative to the first cylindrical portion 146b. The first gear 1412 is spaced from the sixth gear 1446 by the first ring portion 1424, and the fourth rod 1466 rotatably extends through the rotatable hinge 126.

Referring to FIG. 2 and FIG. 4, in some embodiments, the linkage module 14 includes a third gear set 147, a third shaft 148, and a fourth shaft 149. The fourth shaft 149 is connected with the third gear set 147, the second connecting member 143, the second connecting hinge 124, and the rotatable hinge 126. The third shaft 148 is connected with the third gear set 147, the first gear set 141, the second connecting member 143, and the rotatable hinge 126.

In addition, the third shaft 148 is substantially the same as the second shaft 146 in structure. The third shaft 148 includes a third convex portion 1484, a fifth rod 1482, and a sixth rod 1486. The fifth rod 1482 and the sixth rod 1486 are connected to two opposite sides of the third convex portion 1484, respectively. The fifth rod 1482 includes a second non-cylindrical portion and a second cylindrical portion, the second cylindrical portion is connected with the second non-cylindrical portion and the third convex portion 1484. The sixth rod 1486 is in a substantially cylindrical shape. The third gear 1416 and one of the two first ring portions 1434 of the second connecting member 143 are rotatably disposed on the second cylindrical portion. The second non-cylindrical portion may have a cross section in a non-circular shape, such as in a flat ellipse shape, racetrack shape, or triangle shape. The third gear set 147 is disposed at the second non-cylindrical portion.

The fourth shaft 149 is substantially the same as the first shaft 145 in structure. The fourth shaft 149 includes a fourth convex portion 1494, a seventh rod 1492, and an eighth rod 1496. The seventh rod 1492 and the eighth rod 1496 are connected to two opposite sides of the fourth convex portion 1494, respectively. The seventh rod 1492 has a cross section in a non-circular shape, such as in a flat ellipse or racetrack shape. The eighth rod 1496 is in a substantially cylindrical shape. The seventh rod 1492 is connected with the third gear set 147 and the second connecting member 13. The eighth rod 1496 is rotatably connected with the second connecting hinge 124 and the rotatable hinge 126. The fourth shaft 149 can be an integral structure or a combination of the seventh rod 1492, the eighth rod 1496, and the fourth convex portion 1494.

The eighth rod 1496 extends through the rotatable hinge 126 and connects the rotatable hinge 126 with the second connecting hinge 124. The eighth rod 1496 and the rotatable hinge 126 are rotatably connected with the second connecting hinge 124. The sixth rod 1486 is rotatably connected with the rotatable hinge 126.

Referring to FIG. 4, in some embodiments, the third gear set 147 includes a seventh gear 1472, an eighth gear 1474, and a ninth gear 1476. The eighth gear 1474 is rotatably connected with the seventh gear 1472 and the ninth gear 1476. The ninth gear 1476 is disposed on the fourth shaft 149 and non-rotatable relative to the fourth shaft 149. The seventh gear 1472 is fixed on the third shaft 148 and non-rotatable relative to the third shaft 148.

Moreover, the seventh gear 1472 and the ninth gear 1476 are meshed with the eighth gear 1474. An axis about which the eighth gear 1474 rotates is perpendicular to an axis about which the seventh gear 1472 rotates and an axis about which the ninth gear 1476 rotates. It can be understood that the seventh gear 1472 rotates in a direction opposite to a direction in which the ninth gear 1476 rotates. When any one of the seventh gear 1472, the eighth gear 1474, or the ninth gear 1476 rotates, the other two can rotate synchronously, such that the linkage configuration of the linkage module 14 can be realized and the bendable assembly 10 can be driven to rotate synchronously.

The ninth gear 1476 is fixedly connected with the other one of the two second ring portions of the second connecting members 143. The ninth gear 1476 defines a gear through hole in a non-cylindrical shape, such as in a flat ellipse shape or racetrack shape, such that the seventh rod 1492 extends through and cooperates with the gear through hole in the ninth gear 1476 to drive the linkage module 14 to rotate. In an embodiment, a shape of the gear through hole in the ninth gear 1476 cooperates with that of the seventh rod 1492. The seventh gear 1472 is similar in structure to the ninth gear 1476, and therefore will not be described in detail. The seventh gear 1472 is disposed on the third shaft 148, and the seventh gear 1472 is non-rotatable relative to the third shaft 148. A cross-sectional dimension of the ninth gear 1476 is equal to or slightly smaller than that of the second ring portion to ensure the regular appearance and normal rotation of the linkage module 14.

More specifically, in embodiments as illustrated in the drawings, the seventh gear 1472 is disposed on the second non-cylindrical portion of the third shaft 148. The seventh gear 1472 defines a gear through hole that cooperates with a cross-section of the second non-cylindrical portion. The third gear 1416 is fixedly connected to the second ring portion and sleeved on the second cylindrical portion of the third shaft 148, and can rotate relative to the second cylindrical portion. The third gear 1416 is spaced from the seventh gear 1472 by the second ring portion, and the sixth rod 1486 rotatably extends through the rotatable hinge 126.

In an embodiment, in order to improve the stability of the linkage configuration of the linkage module 14, the bendable assembly 10 includes a first plate 15 and a second plate 17. Compared with the second plate 17, the first plate 15 is disposed at the outside of the bendable assembly 10. The third rod 1462 and the fifth rod 1482 extend through the first plate 15 and the second plate 17. The sixth gear 1446 and the seventh gear 1472 are arranged between the first plate 15 and the second plate 17. The first plate 15 and the second plate 17 are non-rotatable relative to the second shaft 146 and the third shaft 148. One of the two first ring portions 1424 of the first connecting member 142 and the first gear 1412 are arranged between the second plate 17 and the second convex portion 1464. One of the two second ring portions of the second connecting member 143 and the third gear 1416 are arranged between the second plate 17 and the third convex portion 1484.

Referring to FIG. 2 and FIGS. 4-6, in some embodiments, the bendable assembly 10 includes a first damping module 16. The first damping module 16 is rotatably disposed on at least one of the first shaft 145 and the second shaft 146. The first damping module 16 is configured to provide rotation resistance when the hinge module 12 is switched between the bent state and the unfolded state.

In an embodiment, the first damping module 16 is rotatably disposed on at least one of the first shaft 145 and the second shaft 146. It can be understood that the first damping module 16 is rotatably disposed on the first shaft 145, or the first damping module 16 is rotatably disposed on the second shaft 146, or the first damping module 16 is rotatably disposed on both the first shaft 145 and the second shaft 146. As illustrated in FIG. 2 and FIGS. 4-6, the first damping module 16 is rotatably disposed on both the first shaft 145 and the second shaft 146. More specifically, the first damping module 16 is rotatably disposed on the second rod 1456 and the fourth rod 1466. The first damping module 16 can provide rotation resistance for the first shaft 145 when the first shaft 145 rotates and further provide rotation resistance when the first damping module 16 is driven by the first shaft 145 to rotate relative to the second shaft 146.

In addition, a portion of the second rod 1456 and a portion of the fourth rod 1466 in contact with the first damping module 16 each can be processed through a cutting process to make part of arc-shaped surfaces be flat surfaces. In this way, frictional forces between the first damping module 16 and the first shaft 145 and friction forces between the first damping module 16 and the second shaft 146 can be increased, thereby providing a relatively stable connection.

The first damping module 16 can increase the rotation resistances when the first damping module 16 rotates relative to the first shaft 145 and second shaft 146, thereby making the hinge module 12 more stable when switching between the bent state and the unfolded state. At this point, the rotation resistances can be adjusted, such that the bendable assembly 10 can be maintained at a folding angle of 0 degree (as illustrated in FIG. 1), a folding angle of 180 degrees (as illustrated in FIG. 2), or a folding angle within a range of 0-180 degrees, thereby satisfying user requirements.

Referring to FIG. 4 and FIG. 8, in some embodiments, the first damping module 16 includes multiple first damping pieces 162 stacked, and each of the multiple first damping pieces 162 defines a first notch 1622. An interference fit is formed between the first damping pieces 162 and at least one of the first shaft 145 and the second shaft 146 via the first notch 1622.

Specifically, in an embodiment illustrated in FIG. 4 and FIG. 8, the first damping pieces 162 defines two first notches 1622 at two opposite ends of the first damping pieces 162. The interference fit is formed between the first shaft 145 and the first damping pieces 162 via one of the two first notches 1622. The interference fit is formed between the second shaft 146 and the first damping pieces 162 via the other of the two first notches 1622. Multiple first damping pieces 162 stacked can provide a relatively large frictional force, i.e., a rotation resistance applied to the hinge module 12, and also space occupied by the hinge module 12 can be reduced, thereby facilitating arrangement of other components. Frictional forces may be generated between the first damping pieces 162 and the first shaft 145 and between the first damping pieces 162 and the second shaft 146, and can be adjusted by adjusting a size of the first notch 1622 or the number of the first damping pieces 162. Alternatively, the frictional forces can be adjusted by choosing the first damping pieces 162 made of relatively smooth or rough materials.

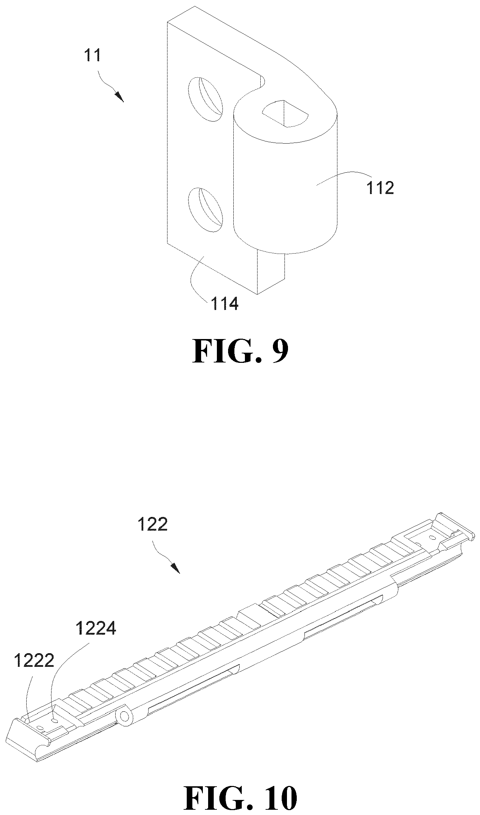

Referring to FIG. 2, FIG. 4, and FIG. 9, in some embodiments, the bendable assembly 10 includes a third connecting member 11. The third connecting member 11 is fixedly connected with the first connecting hinge 122 and the first shaft 145.

In an embodiment, the third connecting member 11 includes a first base plate 114 and a first shaft connector 112 disposed on one side of the first base plate 114. The third connecting member 11 has a cross section in a substantially whistle-shape. The first shaft connector 112 defines a through hole with a non-circular cross section, and the first shaft connector 112 cooperates with the first rod 1452 and is disposed on the first shaft 145, such that the third connecting member 11 is non-rotatable relative to the first shaft 145. The first base plate 114 defines two through holes to allow two first fasteners 116 to extend through. When the linkage module 14 is fixedly connected to the first connecting hinge 122, the first base plate 114 is embedded in the first fastening groove 1222, the first fastener 116 extends through the through hole of the first shaft connector 112 and the first fastening hole 1224 in the first fastening groove 1222, so as to accomplish a fixed connection between the third connecting member 11 and the first connecting hinge 122.

In some embodiment, the bendable assembly 10 includes a second damping module 18, and the second damping module 18 is rotatably disposed on at least one of the third shaft 148 and the fourth shaft 149. The second damping module 18 is configured to provide a rotation resistance when the hinge module 12 is switched between the bent state and the unfolded state.

In an embodiment, the second damping module 18 is rotatably disposed on at least one of the third shaft 148 and the fourth shaft 149. It can be understood that the second damping module 18 is rotatably disposed on the third shaft 148, or the second damping module 18 is rotatably disposed on the fourth shaft 149, or the second damping module 18 is rotatably disposed on the third shaft 148 and the fourth shaft 149. As illustrated in FIG. 2, FIG. 4, and FIG. 9, the second damping module 18 is rotatably disposed on the third shaft 148 and the fourth shaft 149. More specifically, the second damping module 18 is rotatably disposed on the sixth rod 1486 and the eighth rod 1496. The second damping module 18 can provide rotation resistance for the fourth shaft 149 when the fourth shaft 149 rotates, and further provide rotation resistance when the second damping module is driven by the fourth shaft 149 to rotate relative to the third shaft 148.

In addition, a portion of the sixth rod 1486 and a portion of the eighth rod 1496 in contact with the second damping module 18 each can be processed through a cutting process to make part of arc-shaped surfaces be flat surfaces. In this way, frictional forces between the second damping module 18 and the third shaft 148 and friction forces between the second damping module 18 and the fourth shaft 149 can be increased, thereby providing a relatively stable connection.

The second damping module 18 can increase the rotation resistances when the second damping module 18 rotates relative to the third shaft 148 and the fourth shaft 149, thereby making the hinge module 12 more stable when switching between the bent state and the unfolded state. At this point, the rotation resistance can be adjusted, such that the bendable assembly 10 can be maintained at a folding angle of 0 degree (as illustrated in FIG. 1), a folding angle of 180 degrees (as illustrated in FIG. 2), or a folding angle within a range of 0-180 degrees, thereby satisfying user requirements.

As illustrated in FIG. 4, in some embodiments, the second damping module 18 includes multiple second damping pieces 182 stacked, and each of the multiple second damping pieces 18 has a second notch 184. An interference fit is formed between the second damping pieces 182 and at least one of the third shaft 1448 and the fourth shaft 149 via the second notch 184.

Specifically, in an embodiment illustrated in FIG. 4, the second damping pieces 182 defines two second notches 184 at two opposite ends of the second damping pieces 182. The interference fit is formed between the second damping pieces 182 and the third shaft 148 via one of the two second notches 184. The interference fit is formed between the second damping pieces 182 and the fourth shaft 149 via the other of the two second notches 184. Multiple second damping pieces 182 stacked can provide a relatively large frictional force, i.e., a rotation resistance applied to the hinge module 12, and also the space occupied by the hinge module 12 can be reduced, thereby facilitating the arrangement of other components. Frictional forces may be generated between the second damping pieces 182 and the third shaft 148 and between the second damping pieces 182 and the third shaft 149, and can be adjusted by adjusting a size of the second notch 184 or a number of the second damping pieces 182. Alternatively, the frictional forces can be adjusted by choosing the second damping pieces 182 made of relatively smooth or rough materials.

In some embodiments, the bendable assembly 10 includes a fourth connecting member 13. The fourth connecting member 13 is fixedly connected with the second connecting hinge 124 and the fourth shaft 149.

In an embodiment, the fourth connecting member 13 includes a second base plate 134 and a second shaft connector 132 disposed on one side of the second base plate 134. The fourth connecting member 13 has a cross section in a substantially whistle-shape. The second shaft connector 132 defines a through hole with a non-circular cross section, and the second shaft connector 112 cooperates with the seventh rod 1492 and is disposed on the third shaft 148, such that the fourth connecting member 13 is non-rotatable relative to the fourth shaft 149. The second base plate 134 defines two through holes to allow two second fasteners 136 to extend through. When the linkage module 14 is fixedly connected to the second connecting hinge 124, the second base plate 134 is embedded in the second fastening groove 1242, and the second fastener 136 extends through the through hole of the second shaft connector 132 and the second fastening hole 1244 in the second fastening groove 1242, so as to accomplish a fixed connection between the fourth connecting member 13 and the second connecting hinge 124.

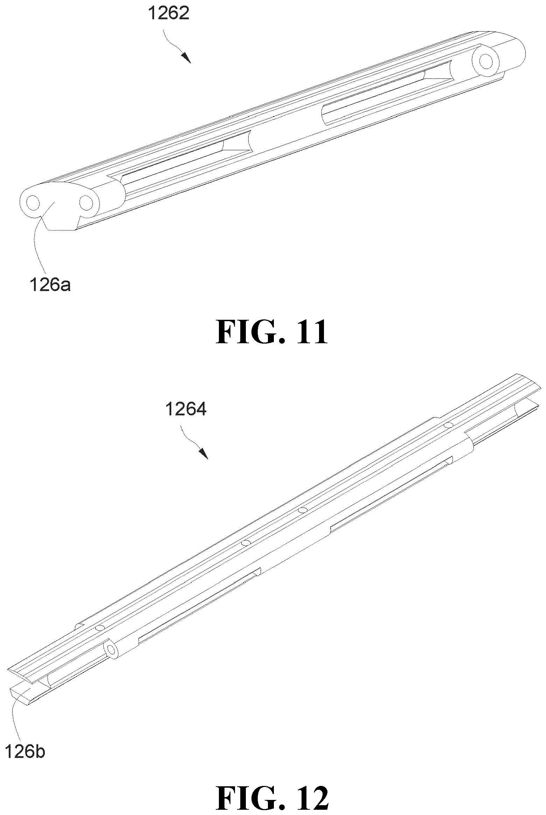

Referring to FIG. 3 and FIGS. 10 to 12, in some embodiments, the rotatable hinge 126 includes a first hinge 1262, a second hinge 1264, and a third hinge 1266. The first hinge 1262 is rotatably connected with the first connecting hinge 122 and the second hinge 1264. The second hinge 1264 is rotatably connected with the first hinge 1262 and the third hinge 1266. The third hinge 1266 is rotatably connected with the second connecting hinge 124 and the second hinge 1264.

In an embodiment, a portion of the first hinge 1262 is rotatably connected with and fitted with a portion of the first connecting hinge 122, and another portion of the first hinge 1262 is rotatably connected with and fitted with a portion of the second hinge 1264. The portion of the second hinge 1264 is rotatably connected with and fitted with the portion of the first hinge 1262, and another portion of the second hinge 1264 is rotatably connected with and fitted with a portion of the third hinge 1266. The portion of the third hinge 1266 is rotatably connected with and fitted with the another portion of the second hinge 1264, and another portion of the third hinge 1266 is rotatably connected with and fitted with a portion of the second connecting hinge 124. The first hinge 1262, the second hinge 1264, and the third hinge 1266 each include a hollow structure, so as to reduce the weight of the rotatable hinge 126, thereby lightening the bendable assembly 10 and the flexible display device 100.

The first hinge 1262 is provided with first connecting portions 126a at two opposite ends of the first hinge 1262. The first connecting portion 126a is connected with the linkage module 14. The first connecting portion 126a defines two shaft holes at two opposite ends of the first connecting portion 126a through which the second rod 1456 of the first shaft 145 and the fourth rod 1466 of the second shaft 146 rotatably pass, respectively, so as to facilitate a connection between the rotatable hinge 126 and the linkage module 14. The first damping module 16 is arranged between the first connecting portion 126a and the first convex portion 1454 and between the first connecting portion 126a and the second convex portion 1464.

The second hinge 1264 is provided with first accommodation spaces 126b at two opposite ends of the second hinge 1264. The second gear 1414 can be accommodated in the first accommodation space 126b, so as to further stabilize the second gear 1414 and prevent debris from entering the gears, thereby improving the reliability of the linkage module 14. The third hinge 1266 is substantially similar to the first hinge 1262 in structure. The third hinge 1266 is provided with second connecting portions at two opposite ends of the third hinge 1266. The second connecting portion of the third hinge 1266 is connected with the linkage module 14. The second connecting portion defines two shaft holes at two opposite ends of the second connecting portion through which the sixth shaft 1486 of the third shaft 148 and the eighth rod 1496 of the fourth shaft 149 rotatably extend, respectively, so as to facilitate the connection between the rotatable hinge 126 and the linkage module 14. The second damping module 18 is arranged between the second connecting portion and the third convex portion 1484 and between the second connecting portion and the fourth convex portion 1494.

In the embodiments illustrated in the drawings, when the bendable assembly 10 is switched between the bent state and the unfolded state, the second shaft 146 and the third shaft 148 are fixed and non-rotatable. When applying an external force to the first connecting hinge 122, the first connecting hinge 122 rotates. The rotation of the first connecting hinge 122 drives the first shaft 145 to rotate via the third connecting member 11. A rotation of the first shaft 145 enables the fourth gear 1442 and the fifth gear 1444 to rotate around the sixth gear 1446, so as to drive the first connecting member 142 and the first gear 1412 to rotate about the second shaft 146. A rotation of the first gear 1412 drives the second gear 1414 to rotate, such that the external force is synchronously transmitted to the third gear 1416. The third gear 1416 drives the second connecting member 143 to rotate, and the rotation of the second connecting member 143 drives the fourth shaft 149 to rotate. The fourth shaft 149 drives the ninth gear 1476 and the eighth gear 1474 to rotate around the seventh gear 1472 and drives the second connecting hinge 124 to rotate via the fourth connecting member 13, such that the first connecting hinge 122 and the second connecting hinge 124 are driven to close to each other, and a synchronous transmission process of the bendable assembly 10 is accomplished.

In addition, in the embodiments illustrated in the drawings, the linkage module 14 has two linkage modules 14, and the two linkage modules 14 are respectively arranged at two opposite ends of the hinge module 12. In this way, the stability of the bendable assembly 10 during rotation can be improved.

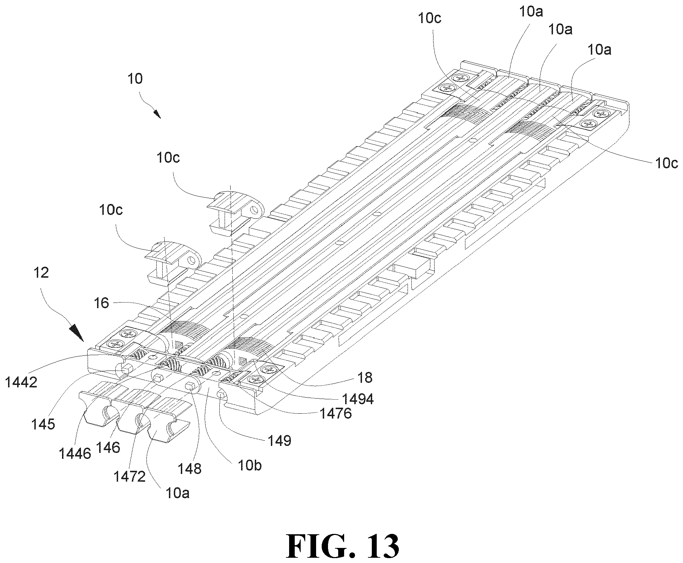

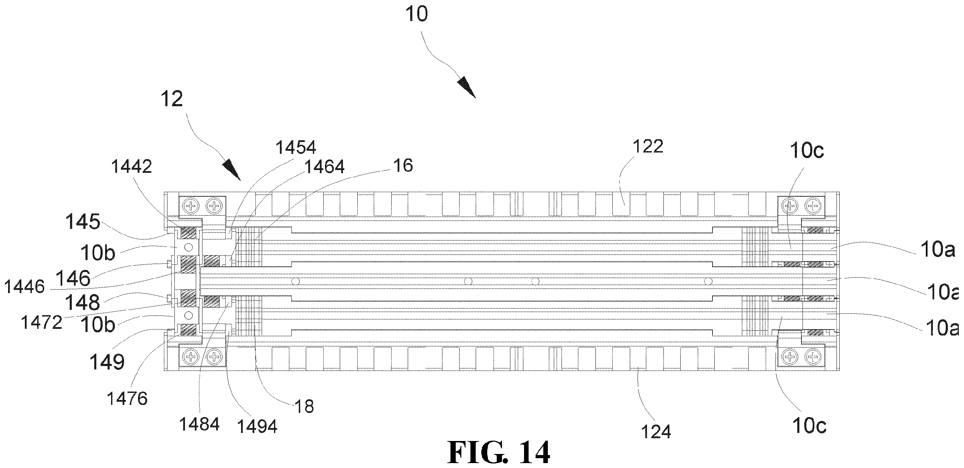

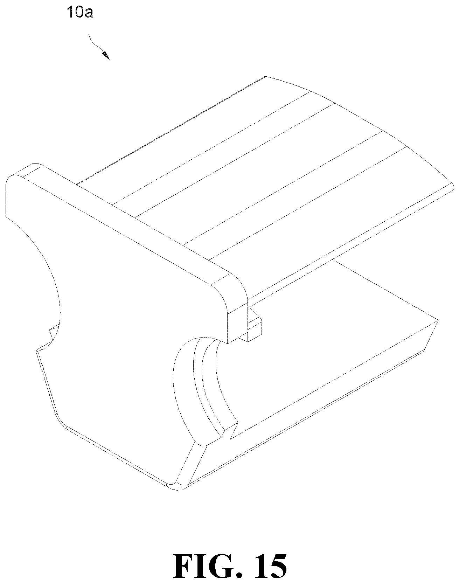

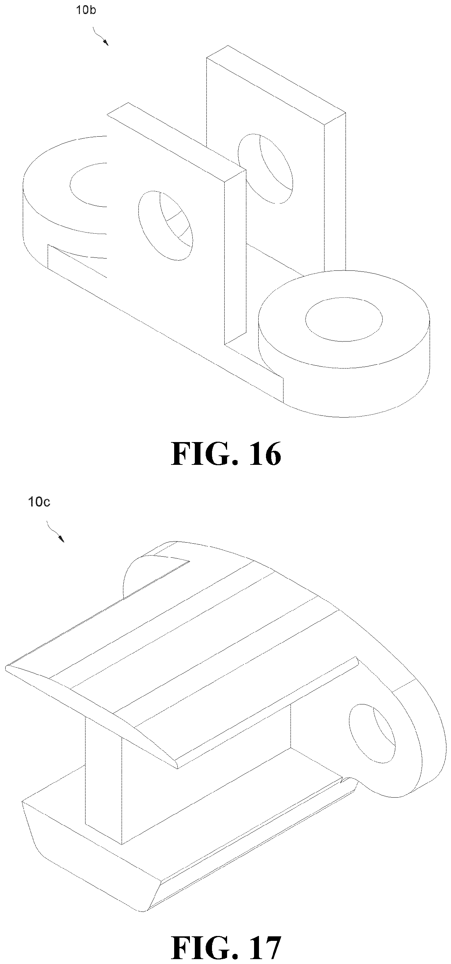

Referring to FIGS. 13-17, in order to further improve the integrity and stability of the bendable assembly 10, the bendable assembly 10 is provided with a first assembling member 10a, a second assembling member 10b, and a third assembling member 10c.

An example in which the first assembling member 10a, the second assembling member 10b, and the third assembling member 10c are disposed at one end of the hinge module 12 is taken for illustration.

There are three first assembling members 10a, two second assembling members 10b, and two third assembling member 10c. The three first assembling members 10a are assembled at one end of the linkage module 14 at intervals and partially cover the second gear set 144 and the third gear set 147. More specifically, partially covering the second gear set 144 and the third gear set 147 can be understood as that a part of the fourth gear 1442, the entire fifth gear 1444, and a part of the sixth gear 1446 are covered by one corresponding first assembling member 10a, and a part of the seventh gear 1472, the entire eighth gear 1474, and a part of the ninth gear 1476 are covered by one corresponding first assembling member 10a. One of the two second assembling members 10b is fixedly disposed between the first shaft 145 and the second shaft 146, and the other one of the two second assembling members 10b is fixedly disposed between the third shaft 148 and the fourth shaft 149. The two second assembling members 10b accommodate the fifth gear 1444 and the eighth gear 1474 respectively, so as to improve structural stability of the second gear set 144 and the third gear set 147. The two first assembling members 10a on two opposite sides respectively accommodate the two second assembling members 10b. One of the two third assembling members 10c extends through the first shaft 145 and the second shaft 146, the other one of the two third assembling members 10c extends through the third shaft 148 and the fourth shaft 149, and the two third assembling members 10c are fixedly connected with the first damping module 16 and the second damping module 18. In an embodiment, the first convex portion 1454, the second convex portion 1464, and the first damping module 16 are fixed to one of the two third assembling members 10c, and the third convex portion 1484, the fourth convex portion 1494, and the second damping module 18 are fixed to the other one of the two third assembling members 10c.

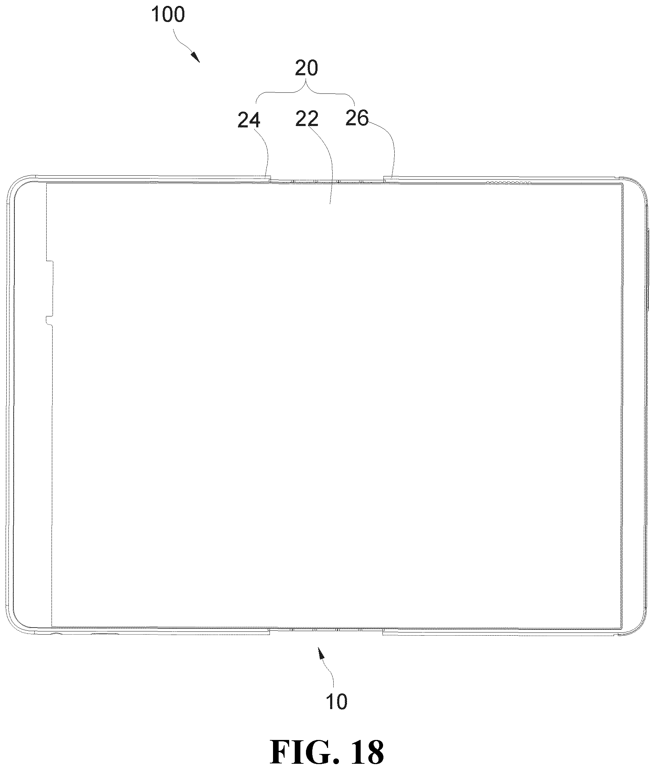

Referring to FIG. 18, the flexible display device 100 according to the embodiments of the present disclosure includes the bendable assembly 10 of any of the above embodiments and a flexible display assembly 20 disposed on the bendable assembly 10.

The flexible display device 100 formed by arranging the flexible display assembly 20 on the bendable assembly 10 allows the flexible display assembly 20 to be changed regularly through the linkage configuration of the bendable assembly 10, thereby improving the user experience and facilitating usage of the flexible display device 100.

In an embodiment, the flexible display assembly 20 can be fixedly disposed on the bendable assembly 10 or detachably disposed on the bendable assembly 10.

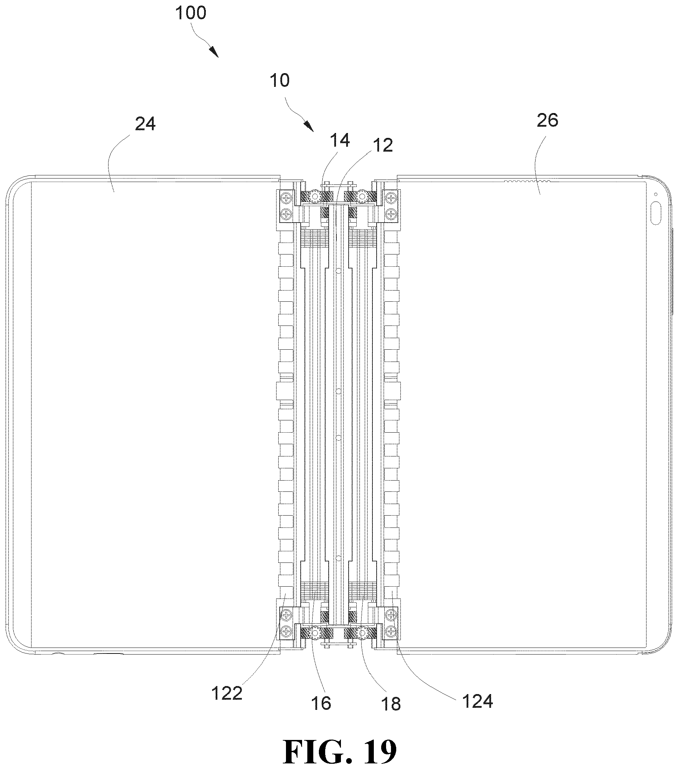

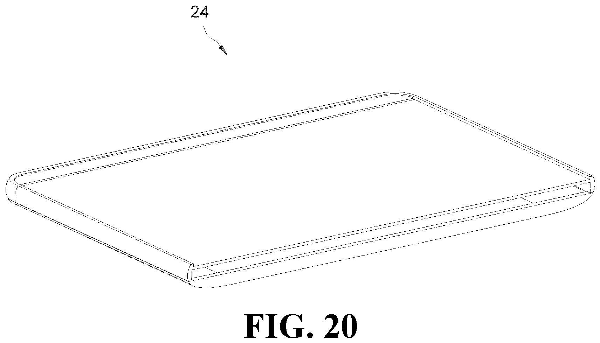

Referring to FIG. 19 and FIG. 20, in some embodiments, the flexible display assembly 20 includes a first support plate 24, a second support plate 26, and a flexible display screen 22. The first support plate 24 is connected with the first connecting hinge 122. The second support plate 26 is connected with the second connecting hinge 124. The flexible display screen 22 is disposed on the first support plate 24 and the second support plate 26.

It is noted that two sides of the bendable assembly 10 are respectively fixedly connected to the first support plate 24 and the second support plate 26. The bendable assembly 10, the first support plate 24, and the second support plate 26 corporate to provide a substantially continuous plane to facilitate the arrangement of the flexible display screen 22. In one example, the first support plate 24 and the second support plate 26 are made of metal or plastic. In this way, the materials of the first support plate 24 and the second support plate 26 can be diversified, which is beneficial to decrease the cost of the bendable assembly 10.

In some embodiments, the flexible display screen 22 includes an OLED display.

In an embodiment, the OLED display also has self-luminous organic electro-excited light diodes, and thus has advantages of no need for a backlight, high contrast, thin thickness, wide viewing angle, and fast response speed. The OLED display can also be used for flexible panels and has a wide operating temperature range and simple structure and manufacturing processes.

In the description of the specification, the description made with reference to terms such as "one embodiment", "some embodiments", "example", "specific example", or "some examples" means that a specific characteristic, structure, material or feature described with reference to the embodiment or example is included in at least one embodiment or example of the present disclosure. In this specification, exemplary descriptions of the foregoing terms do not necessarily refer to a same embodiment or example. In addition, the described specific features, structures, materials, or characteristics may be combined in a proper manner in any one or more of the embodiments or examples.

Although the embodiments of the present disclosure are illustrated and described above, it would be appreciated by those skilled in the art that, changes, modifications, alternatives, and variants can be made in the embodiments without departing from principles and purposes of the present disclosure, and the scope of present disclosure is defined by the claims and their equivalents.

## Claims

1. A bendable assembly comprising:
a hinge module, comprising a first connecting hinge and a second connecting hinge respectively disposed at two opposite sides of the hinge module; and
a linkage module connected and arranged between the first connecting hinge and the second connecting hinge; wherein
when the first connecting hinge rotates, the linkage module transmits a rotation of the first connecting hinge to the second connecting hinge to drive the second connecting hinge to rotate.

2. The bendable assembly of claim 1, wherein
the linkage module comprises a plurality of linked gears; and
the hinge module bends to enable at least two of the plurality of linked gears arranged at opposite outermost sides of the linkage module to rotate in opposite directions to drive the second connecting hinge and the first connecting hinge to rotate toward each other.

3. The bendable assembly of claim 2, wherein
the linkage module comprises a first gear set, a first connecting member, and a second connecting member;
the first connecting member interlocks the first connecting hinge with the first gear set, and the second connecting member interlocks the second connecting hinge with the first gear set; and
the first connecting hinge enables to drive the first connecting member to rotate, the first gear set enables to transmit a rotation of the first connecting member to the second connecting member, and the second connecting member then drives the second connecting hinge to rotate.

4. The bendable assembly of claim 3, wherein the first gear set comprises a first gear, a second gear, and a third gear, wherein the second gear rotatably connects with the first gear and the third gear, the first gear fixedly connects with the first connecting member, and the third gear fixedly connects with the second connecting member.

5. The bendable assembly of claim 4, wherein an axis about which the second gear rotates is perpendicular to an axis about which the first gear rotates and an axis about which the third gear rotates.

6. The bendable assembly of claim 3, wherein
the linkage module comprises a second gear set, a first shaft, and a second shaft;
the first shaft connects with the second gear set, the first connecting member, and the first connecting hinge; and
the second shaft connects with the second gear set, the first gear set, and the first connecting member.

7. The bendable assembly of claim 6, wherein the second gear set comprises a fourth gear, a fifth gear, and a sixth gear, wherein the fifth gear rotatably connects with the fourth gear and the sixth gear, the fourth gear disposes on the first shaft and non-rotatable with respect to the first shaft, and the sixth gear fixes on the second shaft and non-rotatable relative to the second shaft.

8. The bendable assembly of claim 7, wherein an axis about which the fifth gear rotates is perpendicular to an axis about which the fourth gear rotates and an axis about which the sixth gear rotates.

9. The bendable assembly of claim 6, wherein the bendable assembly comprises a first damping module, wherein the first damping module rotatably disposes on at least one of the first shaft and the second shaft, and the first damping module is configured to provide rotation resistance when the hinge module is switched between a bent state and an unfolded state.

10. The bendable assembly of claim 9, wherein the first damping module comprises a plurality of first damping pieces stacked, wherein each of the plurality of first damping pieces defines a first notch, wherein an interference fit is formed between the first damping pieces and at least one of the first shaft and the second shaft via the first notch.

11. The bendable assembly of claim 6, wherein the bendable assembly comprises a third connecting member, wherein the third connecting member fixedly connects with the first connecting hinge and the first shaft.

12. The bendable assembly of claim 3, wherein
the linkage module comprises a third gear set, a third shaft, and a fourth shaft;
the fourth shaft connects with the third gear set, the second connecting member, and the second connecting hinge; and
the third shaft connects with the third gear set, the first gear set, and the second connecting member.

13. The bendable assembly of claim 12, wherein the third gear set comprises a seventh gear, an eighth gear, and a ninth gear, wherein the eighth gear rotatably connects with the seventh gear and the ninth gear, the seventh gear fixes on the third shaft and non-rotatable relative to the third shaft, and the ninth gear disposes on the fourth shaft and non-rotatable relative to the fourth shaft.

14. The bendable assembly of claim 13, wherein an axis about which the eighth gear rotates is perpendicular to an axis about which the seventh gear rotates and an axis about which the ninth gear rotates.

15. The bendable assembly of any of claims 5, 8, or 14, wherein the second gear, the fifth gear, and the eighth gear are all helical gears.

16. The bendable assembly of claim 12, wherein the bendable assembly comprises a second damping module, wherein the second damping module rotatably disposes on at least one of the third shaft and the fourth shaft, and the second damping module is operable to provide rotation resistance when the hinge module is switched between a bent state and an unfolded state.

17. The bendable assembly of claim 16, wherein the second damping module comprises a plurality of second damping pieces stacked, each of the plurality of second damping pieces has a second notch, wherein an interference fit is formed between the second damping pieces and at least one of the third shaft and the fourth shaft via the second notch.

18. The bendable assembly of claim 12, wherein the bendable assembly comprises a fourth connecting member, wherein the fourth connecting member fixedly connects with the second connecting hinge and the fourth shaft.

19. The bendable assembly of claim 2, wherein
the hinge module comprises a rotatable hinge, wherein the first connecting hinge and the second connecting hinge respectively rotatably connect to two opposite sides of the rotatable hinge; and
the rotatable hinge comprises a first hinge, a second hinge, and a third hinge, wherein the first hinge rotatably connects with the first connecting hinge and the second hinge, the second hinge rotatably connects with the first hinge and the third hinge, and the third hinge rotatably connects with the second connecting hinge and the second hinge.

20. A flexible display device comprising the bendable assembly of any of claims 1 to 19 two and arranged and a flexible display assembly disposed on the bendable assembly.
